# EUROPÄISCHE PATENTSCHRIFT

(11) **EP 3 362 801 B1**
(45) Veröffentlichungstag und Bekanntmachung des Hinweises auf die Patenterteilung: **15.09.2021**
(21) Anmeldenummer: 16778803.3
(22) Anmeldetag: 07.10.2016
(51) Int. Cl.: G01R 15/18, G01R 15/20

(54) **SENSORBAUGRUPPE FÜR EINEN STROMSENSOR, SOWIE VERFAHREN ZUR MONTAGE EINER SENSORBAUGRUPPE**
SENSOR ASSEMBLY FOR A CURRENT SENSOR, AND METHOD FOR ASSEMBLING A SENSOR ASSEMBLY
MODULE DE DÉTECTION POUR UN CAPTEUR DE COURANT, ET PROCÉDÉ DE MONTAGE D'UN MODULE DE DÉTECTION

(30) Priorität: 16.10.2015 DE 102015117651
(43) Veröffentlichungstag der Anmeldung: 22.08.2018
(73) Patentinhaber: Harting Electric GmbH & Co. KG, 32339 Espelkamp (DE)
(72) Erfinder: BECKER, Alexander, 33818 Leopoldshöhe (DE); WESEMANN, Matthias, 31606 Warmsen (DE); DRESCHER, Jan, 31552 Apelern (DE)
(74) Vertreter: Prinz & Partner mbB
(86) Internationale Anmeldenummer: PCT/EP2016/073993
(87) Internationale Veröffentlichungsnummer: WO 2017/063947

(56) Entgegenhaltungen:
- WO-A1-94/27343
- WO-A1-2015/140129
- CH-A- 479 283
- DE-A1-102007 035 184
- DE-U1-202010 006 633
- FR-A1- 2 977 775
- GB-A- 2 153 873
- NL-C- 101 700
- NL-C2- 1 007 003
- US-A- 3 090 431
- US-A- 4 584 737
- US-A1- 2013 293 226
- US-A1- 2014 167 750

## Beschreibung

Die Erfindung betrifft eine Sensorbaugruppe für einen Stromsensor. Die Erfindung betrifft weiterhin ein Verfahren zur Montage einer solchen Sensorbaugruppe.

Bei dem erfindungsgemäßen Stromsensor handelt es sich um einen sogenannten Open-Loop-Sensor, der einen ringförmigen Magnetkern aufweist, durch den hindurch sich ein stromführendes Element (beispielsweise eine Stromschiene) erstreckt. Ein Strom, der durch das stromführende Element fließt, erzeugt ein Magnetfeld, welches im Magnetkern konzentriert wird.

Der Magnetkern ist mit mindestens einem Spalt versehen, in welchem ein Hallelement angeordnet ist, mit dem die Stärke des Magnetfeldes im Spalt zwischen den beiden einander gegenüberliegenden Stirnflächen des Magnetkerns gemessen werden kann. Da die Stärke des Magnetfeldes von der Größe des Stroms abhängt, der durch das stromleitende Element fließt, lässt sich aus dem Ausgangssignal des Hallelements auf die Größe des Stroms schließen, der durch das stromleitende Element fließt.

Die Genauigkeit, mit der aus der Stärke des Magnetfeldes im Spalt des Magnetkerns auf die Größe des Stroms geschlossen werden kann, der durch das stromleitende Element fließt, wird neben verschiedenen anderen Faktoren maßgeblich von zwei geometrischen Größen beeinflusst: der Breite des Spalts und der Ausrichtung des Hallelements. Änderungen der Breite des Spalts führen zu einer erheblichen Änderung der Stärke des Magnetfeldes im Spalt. Eine Schrägstellung des Hallelements im Spalt beeinflusst die Stärke des vom Hallelement wahrgenommenen Magnetfeldes.

Es gibt im Stand der Technik verschiedene Ansätze, die Messgenauigkeit eines solchen Stromsensors zu erhöhen.

Aus der EP 2 224 461 A1 ist ein Magnetkern für einen Stromsensor bekannt, bei dem ein Überbrückungselement verwendet wird, das mit dem Magnetkern beiderseits des Schlitzes verschweißt wird. Auf diese Weise sollen Verformungen des Magnetkerns und daraus resultierende Änderungen der Breite des Schlitzes verhindert werden.

Aus der EP 1 965 217 A1 ist ein Stromsensor bekannt, bei dem der Magnetkern in einem Gehäuse fixiert ist. Im Gehäuse ist auch eine Platine mit dem Hallelement fixiert, sodass die Lage des Hallelements relativ zum Schlitz vorgegeben ist.

Aus der WO 2015/140129 A1 ist ein Stromsensor bekannt, bei dem die Platine, an der das Hallelement angebracht ist, mit einem Federelement versehen ist, das sich in den Schlitz zwischen den beiden Stirnflächen des Magnetkerns hinein erstreckt und an diesen Stirnflächen anliegt. Hierdurch soll es möglich sein, die Platine mit dem daran angebrachten Hallelement bei unterschiedlichen Magnetkernen zu verwenden.

Aus der DE 10 2007 035 184 A1 ist ein Stromsensor bekannt, der aus zwei Teilelementen besteht, die um einen Leiter herum angeordnet und dann miteinander verschraubt werden. Hallelemente sind im Inneren der Teilelemente angeordnet, die zu diesem Zweck hohl ausgeführt sind.

Aus der US 2014/0167750 A1 ist ein Stromsensor bekannt, der ein Gehäuse aufweist, das als Halter für Hallelemente und gleichzeitig als Halter für Magnetkerne dient. Die Hallelemente werden vom Halter in Zwischenräumen zwischen den Magnetkernen positioniert.

Die Aufgabe der Erfindung besteht darin, bei geringem Aufwand eine hohe Messgenauigkeit zu ermöglichen.

Zur Lösung dieser Aufgabe ist erfindungsgemäß eine Sensorbaugruppe für einen Stromsensor mit den Merkmalen des Anspruchs 1 vorgesehen.

Die Grundidee der Erfindung besteht darin, einen starren Halter zu verwenden, der eine Doppelfunktion hat: Zum einen dient er als Abstandshalter zwischen den einander gegenüberliegenden Stirnflächen, die den Spalt im Magnetkern begrenzen. Zusammen mit Tape und/oder einer Vergussmasse und/oder anderen Gestaltungen, die den mehrteiligen Magnetkern zusammenhalten, definiert der starre Halter kraftschlüssig den Spalt zwischen den einzelnen Magnetkernteilen. Indem die Stirnflächen des Magnetkerns gegen die Anlageflächen des Halters gedrückt werden, ist mit minimalstem Aufwand sichergestellt, dass der Spalt im Magnetkern eine vordefinierte Breite hat. Diese Breite hängt lediglich von Toleranzen bei der Herstellung des Halters und auch von Wärmeausdehnungen des Halters aufgrund von unterschiedlichen Betriebstemperaturen des Stromsensors ab. Es ist jedoch mit sehr geringem Aufwand möglich, die Toleranzen unterhalb eines Bruchteils eines Millimeters zu halten, insbesondere kleiner 0,1 mm. Zum anderen dient der Halter dafür, das Hallelement so zu fixieren, dass es sich senkrecht zur Richtung der Magnetfeldlinien erstreckt, die durch den Spalt des Magnetkerns verlaufen, wenn in diesem ein Magnetfeld induziert wird. Um das Hallelement mechanisch zu fixieren, weist der Halter eine Aufnahme auf, in die das Hallelement einfach eingeschoben werden kann. Dabei ist es ausreichend, wenn die Breite der Aufnahme geringfügig größer ist als die Dicke des Hallelements; falls gewünscht, kann das Hallelement auch (nahezu) spielfrei in der Aufnahme angeordnet sein. Die Magnetkernteile sind über die Halter mechanisch, insbesondere form- und/oder kraftschlüssig miteinander verbunden. Durch eine derartige Verwendung mehrerer Hallsensoren wird die Erfassungsgenauigkeit des Stromsensors erhöht. Wenn drei oder mehr Spalte und damit auch Hallelemente verwendet werden, kann eine automatische Kompensation des erhaltenen Signals erhalten werden, so dass der Stromsensor weniger empfindlich auf eine exzentrische Anordnung der Stromschiene im Innenraum des Stromsensors reagiert. Gleichzeitig wird die jeweilige Spaltbreite auf diese Weise ausschließlich durch den jeweiligen Halter definiert. Bleibt die Form des Halters über einen vorgegebenen Temperaturbereich konstant oder ändert sich nur geringfügig, so gilt das gleiche automatisch für die Spaltbreite. Aufgrund des Gehäuses mit der Positioniergestaltung für den Halter kann der Halter aus einem anderen Material hergestellt werden kann als das Gehäuse. Außerdem ergibt sich erfindungsgemäß der fertigungstechnische Vorteil, dass der Magnetkern mit den Haltern zunächst separat, insbesondere provisorisch, zusammengefügt werden kann, beispielsweise durch Verkleben und/oder Umwickeln der Anordnung, bestehend aus Magnetkernteilen und dazwischen formschlüssig angeordneter Halter, mit einem elastischen Klebeband, z.B. einem sogenannten "Tape". Anschließend kann diese Anordnung in das Gehäuse eingebracht und dort in die gewünschte Position gebracht und mit einer Vergussmasse vergossen werden. Die korrekte Positionierung der Anordnung kann dadurch erleichtert werden, dass das Gehäuse erste Positionierungsmittel aufweist und dass jeder Halter wenigstens ein zweites Positionierungsmittel aufweist, welches mit mindestens einem der Positioniermittel des Gehäuses zusammen wirkt. Insbesondere kann das erste Positionierungsmittel in einem Steg bestehen und das zweite Positionierungsmittel kann in einem zweiten Schlitz des Halters bestehen. Durch die Positioniergestaltung ist gewährleistet, dass sich der Halter präzise an der gewünschten Stelle im Gehäuse befindet.

Gemäß einer bevorzugten Ausgestaltung der Erfindung ist eine elektronische Schaltung zur Verstärkung der Signale des Hallelements vorgesehen. Eine solche Schaltung kann in die Platine integriert werden, an der auch das Hallelement angebracht ist. Auf diese Weise ergeben sich geringe Abmessungen.

Vorzugsweise ist vorgesehen, dass sich die Aufnahme im Halter parallel zu den Anlageflächen erstreckt. Hierdurch ist automatisch sichergestellt, dass sich das Hallelement mit der gewünschten Ausrichtung relativ zu den Stirnflächen des Spaltes des Magnetkerns erstreckt.

Vorzugsweise ist der Halter mit einer Nut (dem vorstehend angesprochenen zweiten Schlitz) versehen ist, in die die Positioniergestaltung eingreift. Dies ermöglicht es mit geringem Aufwand, den Halter relativ zum Gehäuse zu positionieren, ohne dass eine aufwendige Montage notwendig ist.

Die Nut ist dabei vorzugsweise entgegengesetzt zur Aufnahme ausgerichtet. Dies erleichtert den Montageprozess, da sich die Positioniergestaltung und der Hall-Sensor nicht "ins Gehege kommen".

Vorzugsweise hat der Halter in einer Draufsicht eine H-förmige Gestalt. Der Halter kann somit mit geringem Aufwand in einem Urformverfahren hergestellt werden, z.B. spritzgegossen werden.

Gemäß einer bevorzugten Ausführungsform ist vorgesehen, dass die Aufnahme zu der Seite hin offen ist, die vom Zentrum eines vom Magnetkern umschlossenen Raumes abgewandt ist. Dies ermöglicht es, den Hall-Sensor zusammen mit der ihn tragenden Schaltung "von außen" zu montieren, also von einer Seite, an der der zur Verfügung stehende Raum am wenigsten eingeschränkt ist.

Vorzugsweise besteht der Halter aus einem mechanisch harten, nichtmagnetischen Material, beispielsweise Hartplastik oder Kunstglas. Es sind jedoch auch andere Materialien denkbar, mit denen das Hallelement präzise ausgerichtet und der Abstand zwischen den Stirnflächen des Magnetkerns präzise festgelegt werden kann. Insbesondere im Vergleich mit technischen Lösungen, bei denen das während des Herstellungsprozesses im Spalt zunächst frei stehende Hallelement durch anschließendes Vergießen in die Vergussmasse eingebettet und nach Aushärten der Vergussmasse ausschließlich dadurch in seiner endgültigen Position im Spalt fixiert ist, zeichnet sich die erfindungsgemäße Lösung durch eine viel höhere Präzision und Stabilität insbesondere auch über einen langen Zeitraum, also z.B. auch über mehrere Jahre, aus. Der erfindungsgemäße Halter schwindet nicht, fließt nicht und arbeitet auch nicht, wie dies bei Vergussmasse nach einiger Zeit üblicherweise der Fall ist.

Gemäß einer Ausgestaltung der Erfindung ist vorgesehen, dass die Aufnahme ein Einschnitt ist, der optional mit einer Einführschräge versehen ist. Es hat sich herausgestellt, dass eine geometrisch so einfache Ausgestaltung wie ein Einschnitt ausreichend ist, um das Hallelement ausreichend präzise im Spalt des Magnetkerns zu positionieren. Mittels der optional vorhandenen Einführschräge kann das Einführen des Hallelements in den Einschnitt erleichtert werden.

Zur Lösung der oben genannten Aufgabe ist erfindungsgemäß auch ein Verfahren zur Montage einer erfindungsgemäßen Sensorbaugruppe vorgesehen. Erfindungsgemäß wird dabei zunächst zwischen zwei einander gegenüberliegenden Stirnflächen des Spaltes des Magnetkerns ein Halter angeordnet, der mit einer Aufnahme für ein Hallelement versehen ist. Anschließend wird eine Schaltungsplatine mit einem daran angebrachten Hallelement so montiert, dass das Hallelement zumindest nahezu spielfrei in die Aufnahme eingeschoben wird. Das erfindungsgemäße Verfahren zeichnet sich dadurch aus, dass automatisch eine sehr hohe Fehlersicherheit dahingehend erzielt wird, dass eine nichtkorrekte Positionierung des Hallelements mit geringem Aufwand erkannt werden kann. Da die Aufnahme für das Hallelement nur geringfügig breiter ist als die Dicke des Hallelements, kann das Hallelement nur dann in die Aufnahme eingeschoben werden, wenn es korrekt positioniert ist, also sich senkrecht zur Richtung der Magnetfeldlinien im Spalt erstreckt. Wenn dagegen das Hallelement schräg an der Schaltungsplatine montiert ist oder die Schaltungsplatine bei der Montage nicht korrekt ausgerichtet ist, kann das Hallelement nicht in die Aufnahme eintreten. Daher wird es beim Versuch, die Schaltungsplatine in die korrekte Position zu bewegen, zerstört, sodass bei einer Endkontrolle sofort erkannt werden kann, ob das Hallelement richtig (also in der einzig möglichen Ausrichtung) in der Aufnahme angeordnet ist oder gar nicht.

Der besondere Vorteil der Erfindung besteht darin, dass mit einem kostengünstig herstellbaren Bauteil, nämlich dem Halter, eine Vielzahl von Funktionen erfüllt wird:
- Es wird mit minimalem Aufwand und sehr kleinen Toleranzen die Breite des Spaltes zwischen benachbarten Magnetkernteilen fixiert:
- Es wird mit minimalem Aufwand das Hallelement im Spalt positioniert;
- Die Magnetkernteile können über den Halter relativ zum Gehäuse positioniert werden.
- Die Endkontrolle ist vereinfacht, so dass das Risiko verringert ist, dass fehlerhafte Stromsensoren ausgeliefert werden.

Diese Vorteile sind umso größer, je mehr Halter in einem Sensor verbaut werden.

Die Endkontrolle ist insbesondere deshalb vereinfacht, da nach der Montage des Hallelements anhand der elektrischen Funktion des Stromsensors mit einer einfachen ja/nein - Auswertung überprüft werden kann, ob es in die Aufnahme eingeschoben wurde oder außerhalb der Aufnahme liegt. Befindet sich das Hallelement in der Aufnahme, dann funktioniert der Stromsensor bestimmungsgemäß. Befindet sich das Hallelement außerhalb der Aufnahme, dann funktioniert der Stromsensor überhaupt nicht. Dies ist ein Vorteil insbesondere gegenüber anderen Konstruktionen, bei denen der Hallsensor lediglich vergossen wird und eine leichte Fehlstellung sich rein qualitativ auf die Messgenauigkeit auswirkt. Nach dem Vergießen kann die tatsächliche Lage des Hallelements innerhalb der Vergussmasse nicht mehr (oder allenfalls mit extrem hohem Aufwand wie beispielsweise mittels Röntgentechnik) überprüft werden. Erfindungsgemäß lässt sich dagegen sehr schnell bestimmen, ob das Hallelement korrekt montiert ist: Entweder befindet es sich in der Aufnahme, oder es liegt abgeknickt außerhalb der Aufnahme, was bei der Endkontrolle leicht und eindeutig detektiert werden kann, indem die elektrische Funktion des Stromsensors und damit die elektrische Funktion des Hallelements überprüft wird. Liegt, genauer gesagt, trotz einem durch den Magnetkern verlaufenden Stromdurchfluss kein entsprechendes Signal des Hallelements vor, so ist der Stromsensor erfindungsgemäß als eindeutig defekt zu bezeichnen. Im Gegensatz dazu wäre bei nur leichten Fehlstellungen des Hallelements, wie sie im Stand der Technik möglich sind, eine solche qualitätssichernde Unterscheidung weitaus schwieriger zu treffen, beispielsweise durch die Verwendung eines als perfekt angesehenen Referenzsensors.

Die Erfindung wird nachfolgend anhand einer Ausführungsform beschrieben, die in den beigefügten Zeichnungen dargestellt ist. In diesen zeigen:
- Figur 1 eine Draufsicht auf einen Stromsensor gemäß einer Ausführungsform der Erfindung;
- Figur 2 in vergrößertem Maßstab den Ausschnitt II von Figur 1;
- Figur 3 in einer perspektivischen Ansicht einen beim Stromsensor von Figur 1 verwendeten Halter;
- die Figuren 4a bis 4c den Halter von Figur 3 in einer Draufsicht, einer ersten Seitenansicht und einer zweiten Seitenansicht;
- Figur 5 in einer schematischen Darstellung einen ersten Schritt bei der Montage einer Sensorbaugruppe am Stromsensor;
- Figur 6 den Stromsensor nach einem missglückten Versuch des Einschiebens des Hallelements in den Halter;
- Figur 7 den Stromsensor mit korrekt eingeschobenem Hallelement;
- Figur 8 schematisch den Magnetkern mit Haltern für einen Stromsensor gemäß einer weiteren Ausführungsform der Erfindung; und
- Figur 9 schematisch einen Magnetkern mit Haltern für einen Stromsensor gemäß einer wiederum weiteren Ausführungsform der Erfindung.

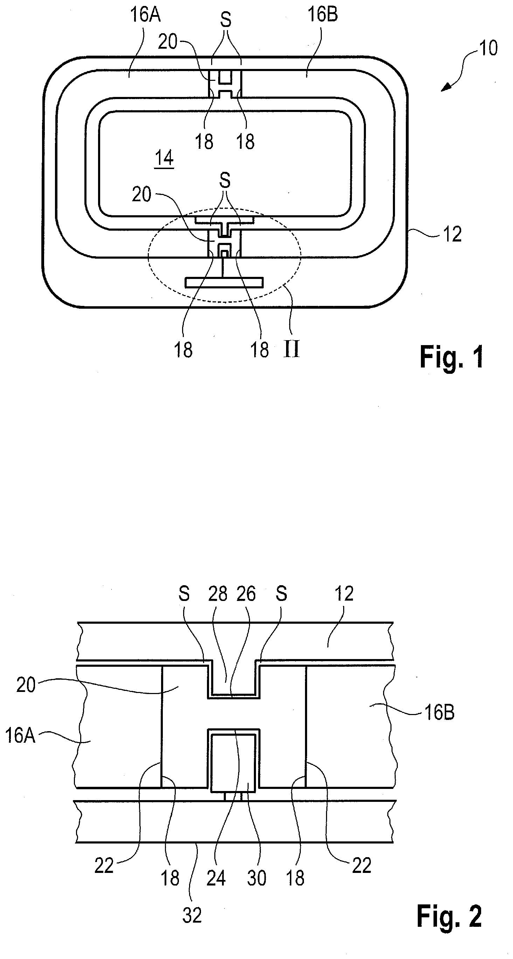

In Figur 1 ist schematisch ein Stromsensor 10 gezeigt, der ein Gehäuse 12 aufweist. Das Gehäuse umschließt einen Innenraum 14, durch den hindurch sich ein stromleitendes Element, beispielsweise eine Stromschiene, erstrecken kann.

Im Inneren des Gehäuses ist ein mehrteiliger Magnetkern 16 so angeordnet, dass er den Innenraum 14 umschließt. Im gezeigten Ausführungsbeispiel besteht der Magnetkern aus zwei Magnetkernhälften 16A, 16B. Diese sind so angeordnet, dass zwischen ihren einander gegenüberliegenden Stirnflächen 18 ein Spalt S vorhanden ist.

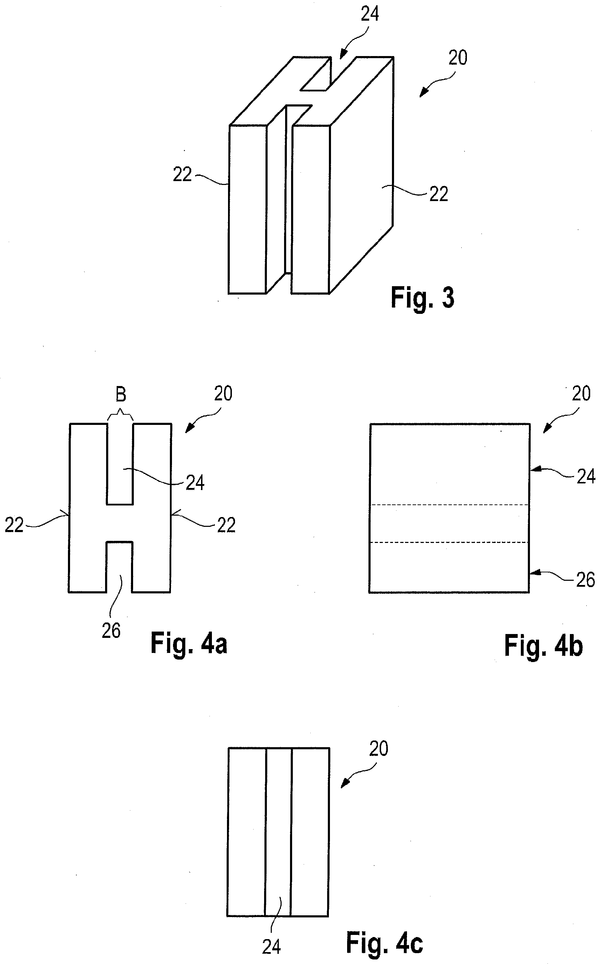

Zwischen den Stirnflächen 18 ist in jedem Spalt S ein Halter 20 angeordnet, der im Detail in den Figuren 3 und 4 gezeigt ist.

Der Halter 20 hat eine quaderförmige Grundform. Zwei voneinander abgewandte Außenflächen bilden Anlageflächen 22, die parallel zueinander verlaufen und dafür vorgesehen sind, dass sich an ihnen die Stirnflächen 18 abstützen, die den Spalt S des Magnetkerns definieren.

Ausgehend von einer weiteren Außenfläche des Halters 20 erstreckt sich eine Aufnahme 24 für ein Hallelement. Die Aufnahme 24 ist hier als gerader, durchgehender Einschnitt mit einer konstanten Breite B ausgeführt, wobei sich der Einschnitt parallel zu den Anlageflächen 22 erstreckt.

Die Aufnahme 24 ist zur vom Innenraum 14 abgewandten Seite hin geöffnet, also auf der Seite des Außenumfangs des Magnetkerns 16.

Auf der von der Aufnahme 24 abgewandten Seite des Halters 20 ist eine Nut 26 vorgesehen, die sich ebenfalls parallel zu den Anlageflächen 22 erstreckt. Somit hat der Halter 20 in einer Draufsicht (siehe Figur 4a) eine H-förmige Gestalt.

Die Nut 26 ist also dem Zentrum des vom Magnetkern 16 umschlossenen Raums (dem Innenraum 14) zugewandt und damit entgegengesetzt zur Aufnahme 24 ausgerichtet.

Abweichend vom gezeigten Ausführungsbeispiel können unterschiedliche Breiten für die Aufnahme 24 und die Nut 26 verwendet werden. Auch können die Tiefe der Aufnahme 24 und der Nut 26 je nach den Anforderungen im Einzelfall anders gewählt werden, als dies in den Zeichnungen gezeigt ist.

Als Material für den Halter 20 wird ein mechanisch hartes, nichtmagnetisches Material verwendet. Besonders geeignet ist hier Hartplastik oder Kunstglas. Die generelle Anforderung an das verwendete Material besteht darin, dass es sich bei Belastungen nicht verformt. Weiterhin soll es einen möglichst geringen Wärmeausdehnungskoeffizienten haben.

Vorzugsweise wird der Halter unter Verwendung einer Form hergestellt, beispielsweise spritzgegossen. Dies ermöglicht, ihn mit sehr hoher Präzision und Formgenauigkeit herzustellen.

Wie insbesondere in Figur 2 zu sehen ist, liegen die Stirnflächen 18, die den Spalt S definieren, flächig an den Anlageflächen 22 des Halters 20 an. Da der Halter 20 aus einem mechanisch harten Material besteht, definiert er sehr präzise die Breite des Spaltes S zwischen den Stirnflächen 18. In einer ersten Ausführungsform ist das Gehäuse 12 vorzugsweise so ausgeführt, dass die in ihm angeordneten Magnetkernteile 16A, 16B mechanisch gegen die Anlageflächen 22 des jeweiligen Halters 20 beaufschlagt werden und so den Halter 20 kraftschlüssig im Spalt S fixieren.

In einer anderen Ausführungsform werden die Magnetkerne 16A, 16B zunächst außerhalb des Gehäuses 12 einander gegenüberliegend angeordnet, wobei sich die Halter 20 zwischen ihren Stirnflächen 18 befinden. Durch eine provisorische kraftschlüssige Fixierung, z.B. durch das Umwickeln des Magnetkerns 16 mit einem elastischen Klebeband ("Tape"), werden die Halter 20 kraftschlüssig zwischen den Magnetkernteilen 16A,16B gehalten. Alternativ könnten die Halter 20 beispielsweise auch an den Stirnflächen verklebt werden. Dann kann die Anordnung aus Magnetkernteilen 16A, 16B und den beiden Haltern 20 in das Gehäuse eingebracht werden.

Die Nut 26 der Halter 20 dient dazu, diese im Gehäuse 12 zu positionieren. Zu diesem Zweck ist das Gehäuse 12 mit einer Positioniergestaltung 28 versehen. Diese ist hier als Steg ausgeführt, der zur Nut 26 komplementär ist. Durch die Positionierung der Halter ist automatisch die Anordnung aus Magnetkernteilen 16A, 16B und Haltern 20 im Gehäuse an der dafür vorgesehenen Stelle positioniert.

Gemäß einer alternativen, nicht gezeigten Ausführungsform kann grundsätzlich auch vorgesehen sein, dass der Halter 20 einstückig mit dem Gehäuse 12 ausgeführt ist. In diesem Fall wird anstelle der Konstruktion aus Nut 26 und Positioniergestaltung 28 eine einstückige Materialverbindung vorgesehen.

Die Aufnahme 24 dient dazu, ein Hallelement 30 aufzunehmen, das an einer Schaltungsplatine 32 angebracht ist. Auf der Schaltungsplatine 32 kann auch eine Elektronikschaltung angebracht sein, mit der beispielsweise das Ausgangssignal des Hallelements 30 verstärkt wird.

Die Abmessungen des Hallelements 30 und der Aufnahme 24 sind aneinander angepasst. Insbesondere entspricht die Breite B der Aufnahme 24 der Dicke des Hallelements 30, oder die Breite B ist geringfügig größer als die Dicke des Hallelements 30. Die Breite B der Aufnahme 24 ist dabei so gewählt, dass einerseits das Hallelement 30 in der Längsrichtung der Aufnahme 24 in diese eingeschoben werden kann, andererseits die Aufnahme 24 die Ausrichtung des Hallelements 30 vorgibt. Insbesondere gewährleistet die Aufnahme 24, dass sich das Hallelement 30 parallel zu den Anlageflächen 22 und den Stirnflächen 18 und damit senkrecht zur Richtung von Magnetfeldlinien erstreckt, die durch den Spalt S hindurch verlaufen, wenn ein sich durch den Innenraum 14 erstreckendes, stromführendes Element von Strom durchflossen wird.

In den Figuren ist der besseren Übersichtlichkeit halber der Halter 20 um 90 Grad um eine in der Richtung der Magnetfeldlinien verlaufende Achse verdreht dargestellt. Dabei ist die Aufnahme 24 zu derjenigen Seite hin offen, die vom Zentrum eines vom Magnetkern 16 umschlossenen Raumes abgewandt ist. In der Praxis liegt die Aufnahme 24 (bezogen auf die Figuren 1 und 2) "oben", so dass die Schaltungsplatine 32 in den Figuren die Aufnahme 24 abdecken würde und die Aufnahme 24 nicht sichtbar wäre. Im letzteren Fall ist die Aufnahme zu derjenigen Seite hin offen, die von einer Rückseite des Gehäuses 12 abgewandt ist.

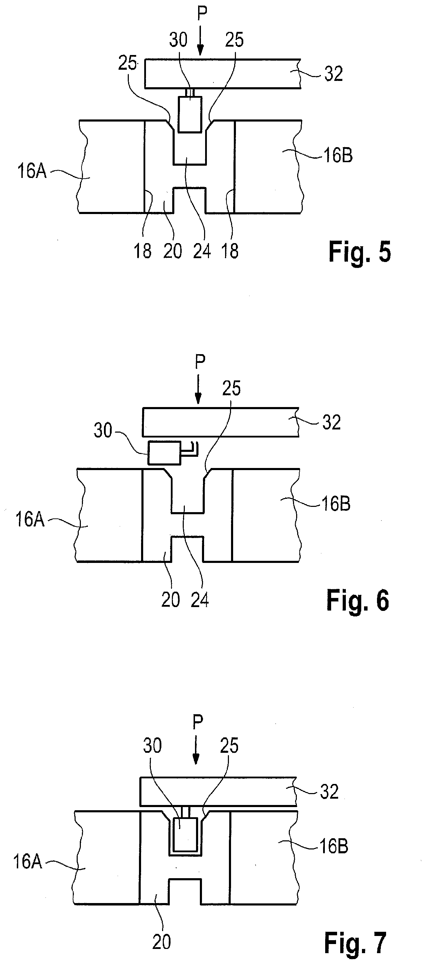

Anhand der Figuren 5 bis 7 wird nachfolgend die Montage des Stromsensors 10 erläutert.

In einem ersten Schritt wird der Halter 20 zwischen den Stirnflächen 18 angeordnet. Die Magnetkernteile 16A, 16B werden dabei so gegen den Halter beaufschlagt, dass der Halter 20 präzise die Breite des Spaltes S bestimmt.

Anschließend wird die Schaltungsplatine 32 mit dem daran angebrachten Hallelement 30 bereitgestellt. Das Hallelement 30 steht im Wesentlichen senkrecht von der Oberfläche der Schaltungsplatine 32 ab.

Um die Schaltungsplatine 32 am Stromsensor zu montieren, wird diese in der Richtung des Pfeils P so verschoben, dass das Hallelement 30 in die Aufnahme 24 eingeschoben wird. In der Praxis ist die Richtung P parallel zur Erstreckungsrichtung einer Stromschiene ausgerichtet, die sich durch den Innenraum 14 des Stromsensors 10 erstreckt.

Wenn das Hallelement 30 an der Schaltungsplatine 32 nicht korrekt ausgerichtet angebracht ist, die Schaltungsplatine 32 nicht korrekt relativ zum Halter 20 positioniert ist oder eine sonstige Fehlausrichtung vorliegt, gelangt das Hallelement 30, wenn die Schaltungsplatine 32 in der Richtung des Pfeils P verstellt wird, nicht in die Aufnahme 24 hinein. Hierdurch ist gewährleistet, dass das Hallelement 30 bei der Fehlmontage zerstört wird (siehe Figur 6, in der zur Verdeutlichung ein abgeknicktes Hallelement 30 gezeigt ist). Dieser Zustand kann bei der anschließenden Kontrolle oder auch bei einer Endkontrolle des Stromsensors mit geringem Aufwand zuverlässig erfasst werden, indem die elektrische Funktion des Stromsensors 10 getestet wird.

Wenn dagegen das Hallelement 30 relativ zur Aufnahme 24 korrekt ausgerichtet ist, wird es problemlos in den Halter 20 eingeschoben (siehe Figur 7). Dabei gewährleistet die Aufnahme 24, dass das Hallelement 30 innerhalb des Spaltes S korrekt ausgerichtet ist.

Wenn gewünscht, kann das Einschieben des Hallelements 30 in die Aufnahme 24 des Halters dadurch erleichtert werden, dass am Rand der Aufnahme 24 jeweils eine Einführschräge 25 (siehe insbesondere Figur 5) vorgesehen ist.

Sobald das Hallelement in den Halter 20 eingeführt ist, kann die Anordnung, bestehend aus den Magnetkernteilen 16A, 16B, den dazwischen befindlichen Haltern 20 und den darin eingeführten Hallelementen 30 im Gehäuse 12 mit einer Vergussmasse vergossen werden.

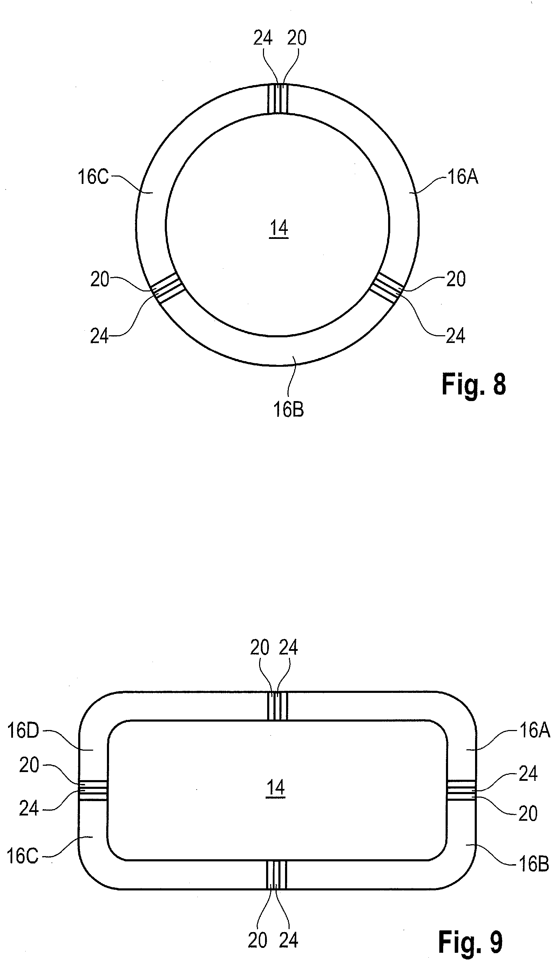

In Figur 8 ist schematisch der Magnetkern mit Haltern 20 für einen Stromsensor gemäß einer weiteren Ausführungsform gezeigt. Für die von der vorhergehenden Ausführungsform bekannten Bauteile werden dieselben Bezugszeichen verwendet, und es wird insoweit auf die obigen Erläuterungen verwiesen.

Der Unterschied zwischen der Ausführungsform gemäß Figur 8 und der ersten Ausführungsform besteht darin, dass der Magnetkern hier kreisförmig ist und insgesamt drei Spalte S vorgesehen sind. Somit sind drei Magnetkernteile 16A, 16B, 16C vorhanden, die sich jeweils über einen Winkelbereich von knapp 120° erstrecken. In jedem der Spalte S ist ein Halter 20 angeordnet, der mit einem (hier nicht gezeigten) Hallelement 30 bestückt ist.

Der Vorteil dieser Ausführungsform besteht darin, dass der Stromsensor 10 weniger empfindlich auf eine exzentrische Anordnung der Stromschiene im Innenraum 14 reagiert. Wenn die Stromschiene exzentrisch angeordnet und daher weiter von einem Hallelement 30 angeordnet ist, ist sie automatisch näher an mindestens einem der beiden anderen Hallelemente 30 angeordnet. Hierdurch ergibt sich eine automatische Kompensation des insgesamt gemessenen Signals für die Stromstärke.

In Figur 9 ist schematisch der Magnetkern mit Haltern für einen Stromsensor gemäß einer dritten Ausführungsform gezeigt. Für die von den vorhergehenden Ausführungsformen bekannten Bauteile werden dieselben Bezugszeichen verwendet, und es wird insoweit auf die obigen Erläuterungen verwiesen.

Der Unterschied zwischen der Ausführungsform gemäß Figur 9 und der ersten Ausführungsform besteht darin, dass der Magnetkern hier mit insgesamt vier Spalten S vorgesehen ist, nämlich jeweils einem an jeder geraden Seite des allgemein rechteckigen Magnetkerns 16. Der Magnetkern 16 besteht somit aus vier Magnetkernteilen 16A bis 16D, die jeweils einen Radiusabschnitt, der sich über 90° erstreckt, und einen sich daran anschließenden langen und einen kurzen Schenkel aufweisen. Auch hier ist in jedem Spalt S ein Halter 20 angeordnet, der mit einem (hier nicht gezeigten) Hallelement 30 bestückt ist.

Auch bei der dritten Ausführungsform ergibt sich der Vorteil, dass der Stromsensor weniger empfindlich auf eine exzentrische Anordnung der Stromschiene im Innenraum 14 reagiert. Wenn die Stromschiene exzentrisch angeordnet und daher weiter von einem Hallelement 30 entfernt ist, ist sie automatisch näher an mindestens einem der drei anderen Hallelemente 30 angeordnet, wodurch das in den vier Spalten S insgesamt gemessene Magnetfeld (zumindest annähernd) konstant bleibt.

## Patentansprüche

1. Sensorbaugruppe für einen Stromsensor (10), mit mindestens zwei Hallelementen (30) und mindestens zwei Haltern (20) für die Hallelemente (30), wobei die Halter (20) starr sind und jeweils eine Aufnahme (24) für das dazugehörige Hallelement (30) aufweisen, in der dieses mit geringen Toleranzen aufgenommen ist, wobei jeder Halter (20) weiterhin zwei Anlageflächen (22) für einen mehrteiligen Magnetkern (16) besitzt, wobei ein mehrteiliger Magnetkern (16) vorgesehen ist, wobei im Spalt (S) zwischen zwei Magnetkernteilen (16A-D) der Halter (20) so angeordnet ist, dass sich das Hallelement (30) senkrecht zu einer Richtung erstreckt, in der Magnetfeldlinien durch den Spalt (S) hindurch verlaufen, wobei ein Gehäuse (12) vorgesehen ist, das eine Positioniergestaltung (28) für den Halter (20) aufweist, mittels der die Position des Halters (20) relativ zum Gehäuse (12) fixiert ist.

2. Sensorbaugruppe nach Anspruch 1, **dadurch gekennzeichnet, dass** eine elektronische Schaltung zur Verstärkung der Signale des Hallelements (30) vorgesehen ist.

3. Sensorbaugruppe nach Anspruch 1 oder Anspruch 2, **dadurch gekennzeichnet, dass** sich die Aufnahme (24) parallel zu den Anlageflächen (22) erstreckt.

4. Sensorbaugruppe nach einem der vorhergehenden Ansprüche, **dadurch gekennzeichnet, dass** die Magnetkernteile (16A-D) über die Halter (20) kraftschlüssig miteinander verbunden sind, wodurch der Magnetkern (16) mindestens zwei Spalte aufweist, in denen jeweils ein Halter (20) kraftschlüssig fixiert ist, wobei die Halter (20) durch ihre Form die Spaltbreite definieren.

5. Sensorbaugruppe nach einem der vorhergehenden Ansprüche, **dadurch gekennzeichnet, dass** der Halter (20) mit einer Nut (26) versehen ist, in die die Positioniergestaltung (28) eingreift.

6. Sensorbaugruppe nach Anspruch 5, **dadurch gekennzeichnet, dass** die Nut entgegengesetzt zur Aufnahme (24) ausgerichtet ist.

7. Sensorbaugruppe nach Anspruch 6, **dadurch gekennzeichnet, dass** der Halter (20) in einer Draufsicht eine H-förmige Gestalt hat.

8. Sensorbaugruppe nach einem der vorhergehenden Ansprüche, **dadurch gekennzeichnet, dass** die Aufnahme (24) entweder zu derjenigen Seite hin offen ist, die vom Zentrum eines vom Magnetkern (16) umschlossenen Raumes abgewandt ist, oder, dass die Aufnahme (24) zu derjenigen Seite hin offen ist, die von einer Rückseite des Gehäuses (12) abgewandt ist.

9. Sensorbaugruppe nach einem der vorhergehenden Ansprüche, **dadurch gekennzeichnet, dass** der Halter aus einem mechanisch harten, nichtmagnetischen Material besteht, vorzugsweise Hartplastik oder Kunstglas.

10. Sensorbaugruppe nach Anspruch 9, **dadurch gekennzeichnet, dass** die Aufnahme (24) ein Schlitz ist, der optional mit einer Einführschräge (25) versehen ist.

11. Verfahren zur Montage einer Sensorbaugruppe nach einem der vorhergehenden Ansprüche, wobei die folgenden Schritte vorgesehen sind:
- zwischen zwei einander gegenüberliegenden Stirnflächen (18) des Spaltes (S) des Magnetkerns (16) wird ein Halter (20) angeordnet, der mit einer Aufnahme (24) für ein Hallelement (30) versehen ist,
- eine Schaltungsplatine (32) mit einem daran angebrachten Hallelement (30) wird so montiert, dass das Hallelement (30) zumindest nahezu spielfrei in die Aufnahme (24) eingeschoben wird.

12. Verfahren nach Anspruch 11, **dadurch gekennzeichnet, dass** nach der Montage des Hallelements (30) anhand der elektrischen Funktion der Sensorbaugruppe (10) überprüft wird, ob das Hallelement (30) in die Aufnahme (24) eingeschoben wurde oder außerhalb der Aufnahme (24) liegt.

## Claims

1. A sensor assembly for a current sensor (10), comprising at least two Hall elements (30) and at least two holders (20) for the Hall elements (30), the holders (20) being rigid and each including a retainer (24) for the associated Hall element (30), in which it is received with small tolerances, each holder (20) further having two contact surfaces (22) for a multipart magnetic core (16), a multipart magnetic core (16) being provided, the holder (20) being arranged in the gap (S) between two magnetic core parts (16A-D) such that the Hall element (30) extends perpendicularly to a direction in which magnetic field lines pass through the gap (S), a housing (12) being provided which has a positioning formation (28) for the holder (20), the position of the holder (20) relative to the housing (12) being fixed by means of the positioning formation (28).

2. The sensor assembly according to claim 1, **characterized in that** an electronic circuit is provided for amplifying the signals of the Hall element (30).

3. The sensor assembly according to claim 1 or claim 2, **characterized in that** the retainer (24) extends parallel to the contact surfaces (22).

4. The sensor assembly according to any of the preceding claims, **characterized in that** the magnetic core parts (16A-D) are connected to each other in a force-locking manner by means of the holders (20), whereby the magnetic core (16) has at least two gaps in each of which a holder (20) is fixed in place in a force-locking manner, the holders (20) defining the gap widths by their shapes.

5. The sensor assembly according to any of the preceding claims, **characterized in that** the holder (20) is provided with a groove (26) in which the positioning formation (28) engages.

6. The sensor assembly according to claim 5, **characterized in that** the groove is oriented oppositely to the retainer (24).

7. The sensor assembly according to claim 6, **characterized in that** in a top view, the holder (20) has the shape of an H.

8. The sensor assembly according to any of the preceding claims, **characterized in that** the retainer (24) is open either toward that side which faces away from the center of a space enclosed by the magnetic core (16), or that the retainer (24) is open toward that side which faces away from a rear side of the housing (12).

9. The sensor assembly according to any of the preceding claims, **characterized in that** the holder consists of a mechanically hard, non-magnetic material, preferably hard plastics or acrylic glass.

10. The sensor assembly according to claim 9, **characterized in that** the retainer (24) is a slot optionally provided with an insertion bevel (25).

11. A method of assembling a sensor assembly according to any of the preceding claims, the following steps being provided:
- arranging a holder (20) between two opposite end faces (18) of the gap (S) of the magnetic core (16), the holder (20) being provided with a retainer (24) for a Hall element (30);
- mounting a circuit board (32) with a Hall element (30) fitted thereto, in such a manner that the Hall element (30) is inserted into the retainer (24) at least almost without clearance.

12. The method according to claim 11, **characterized in that**, after mounting the Hall element (30), it is checked on the basis of the electrical function of the sensor assembly (10) whether the Hall element (30) has been inserted into the retainer (24) or is outside the retainer (24).

## Revendications

1. Ensemble de détection pour un capteur de courant (10), comprenant au moins deux éléments à effet Hall (30) et au moins deux supports (20) pour les éléments à effet Hall (30), les supports (20) étant rigides et présentant chacun un logement (24) pour l'élément à effet Hall (30) associé dans lequel celui-ci est reçu avec peu de tolérances, chaque support (20) présentant en outre deux faces d'appui (22) pour un noyau magnétique (16) en plusieurs parties, un noyau magnétique (16) en plusieurs parties étant prévu, le support (20) étant agencé dans la fente (S) entre deux parties (16A-D) de noyau magnétique de telle sorte que l'élément à effet Hall (30) s'étend perpendiculairement à un sens selon lequel des lignes de champ magnétique s'étendent à travers la fente (S), un boîtier (12) qui présente une conformation de positionnement (28) pour le support (20) et au moyen duquel la position du support (20) par rapport au boîtier (12) est fixée étant prévu.

2. Ensemble de détection selon la revendication 1, **caractérisé en ce qu'**il est prévu un circuit électronique pour le renforcement des signaux de l'élément à effet Hall (30).

3. Ensemble de détection selon la revendication 1 ou la revendication 2, **caractérisé en ce que** le logement (24) s'étend de manière parallèle aux faces d'appui (22).

4. Ensemble de détection selon l'une des revendications précédentes, **caractérisé en ce que** les parties (16A-D) de noyau magnétique sont reliées les unes aux autres par coopération de forces au moyen des supports (20), grâce à quoi le noyau magnétique (16) présente au moins deux fentes dans lesquelles un support (20) respectif est fixé par coopération de forces, les supports (20) définissant la largeur de la fente par leur forme.

5. Ensemble de détection selon l'une des revendications précédentes, **caractérisé en ce que** le support (20) est pourvu d'une rainure (26) dans laquelle la conformation de positionnement (28) s'engage.

6. Ensemble de détection selon la revendication 5, **caractérisé en ce que** la rainure est orientée de manière opposée par rapport au logement (24).

7. Ensemble de détection selon la revendication 6, **caractérisé en ce que** dans une vue de dessus, le support (20) présente la forme d'un H.

8. Ensemble de détection selon l'une des revendications précédentes, **caractérisé en ce que** soit le logement (24) est ouvert vers le côté détourné du centre d'un espace renfermé par le noyau magnétique (16), soit le logement (24) est ouvert vers le côté qui est détourné d'une face arrière du boîtier (12).

9. Ensemble de détection selon l'une des revendications précédentes, **caractérisé en ce que** le support est réalisé en un matériau mécaniquement dur et non-magnétique, de préférence en plastique dur ou en verre synthétique.

10. Ensemble de détection selon la revendication 9, **caractérisé en ce que** le logement (24) est une fente qui est optionnellement pourvue d'un chanfrein d'insertion (25).

11. Procédé de montage d'un ensemble de détection selon l'une des revendications précédentes, les étapes suivantes étant prévues :
- un support (20) qui est pourvu d'un logement (24) pour un élément à effet Hall (30) est agencé entre deux faces frontales (18) opposées l'une à l'autre de la fente (S) du noyau magnétique (16),
- une plaquette à circuits imprimés (32) avec un élément à effet Hall (30) fixé sur celle-ci est montée de telle sorte que l'élément à effet Hall (30) est inséré dans le logement (24) au moins pratiquement sans jeu.

12. Procédé selon la revendication 11, **caractérisé en ce qu'**après le montage de l'élément à effet Hall (30), il est vérifié au moyen de la fonction électrique de l'ensemble de détection (10) si l'élément à effet Hall (30) a été inséré dans le logement (24) ou se trouve à l'extérieur du logement (24).
